# DEMANDE DE BREVET EUROPEEN

(11) **EP 0 807 975 A1**
(43) Date de publication de la demande: **19.11.1997**
(21) Numéro de dépôt: 97401035.7
(22) Date de dépôt: 07.05.1997
(51) Int. Cl.: H01L 25/11, H01L 23/40

(54) **Dispositif à éléments semiconducteurs de puissance**

(30) Priorité: 14.05.1996 FR 9605990
(71) Demandeur: GEC ALSTHOM TRANSPORT SA, 75116 Paris (FR)
(72) Inventeur: Dubelloy, Jean-Luc, 65000 Tarbes (FR); Donnet, Serge, 73100 Aix Les Bains (FR); Compagnet, Bernard, 65430 Soues (FR); Scali, Gérard, 65310 Odos (FR)
(74) Mandataire: Fournier, Michel

(57) **Abrégé**

La présente invention porte sur un dispositif à éléments semi-conducteurs de puissance caractérisé en ce qu'il comprend en combinaison:
- une pile comportant, de façon alternée, au moins un élément semi-conducteur E de puissance et au moins un radiateur R assurant le rôle de dissipateur thermique et de liaison électrique,
- au moins un premier système de serrage (1) des éléments semi-conducteurs de puissance,
- au moins un second système de serrage (2) des composants assurant la protection des éléments semi-conducteurs de puissance,
- au moins une cale (3, 4, 5, 6) permettant d'isoler l'ensemble des éléments semi-conducteurs par rapport à l'ossature des différents modules,
- au moins un pavé conducteur (7) remplaçant les radiateurs R n'étant pas rendus nécessaires grâce au choix du mode d'implantation dans les fonctions onduleur et hacheur auxiliaire.

## Description

La présente invention concerne la disposition des éléments semi-conducteurs de puissance, en général, et porte, plus particulièrement, sur un dispositif à éléments semi-conducteurs de puissance.

Les convertisseurs statiques ou les semi-conducteurs de puissance nécessitent un refroidissement performant dissipant suffisamment de calories.

Les convertisseurs statiques ou les semi-conducteurs de puissance de l'art antérieur ont une architecture dans laquelle les éléments semi-conducteurs ne sont pas tous répartis selon un seul axe.

Les convertisseurs statiques comportant un ensemble de thyristors, de thyristor à extinction commandée par la gâchette (GTO), de diodes et de semi-conducteurs de protection ont une topologie telle que les axes des semi-conducteurs sont soit parallèles, soit sécants, mais jamais tous sur un même axe.

Une telle implantation selon l'art antérieur des éléments semi-conducteurs a pour inconvénient de nécessiter au moins un système de serrage des semi-conducteurs par axe, d'où des coûts élevés, un poids et un volume important.

De plus, une conception selon l'art antérieur des modules de puissance imposant plusieurs axes ne permet pas d'avoir un câblage simple reliant tous les semi-conducteurs.

Ce type de câblage peut devenir très complexe et peut aboutir à un système où la self de câblage est difficilement minimale.

Par voie de conséquence les performances de ce type de convertisseur peuvent être réduites du fait de tels modes de câblage.

Afin de minimiser le système de refroidissement, les modules qui ont une conception bi axes, voire multi axes, ont une architecture adaptée à la fonction électrique.

Il résulte de ce qui précède que la mécanique, le câblage et le mode de refroidissement sont chacun adapté à chacune des fonctions des modules.

En d'autres termes, un module du type onduleur, un module du type pont mixte à commutation forcée (PMCF) et un module du type hacheur auxiliaire, ont chacun une mécanique, un câblage et un mode de refroidissement.

Si le schéma fait appel à d'autres fonctions, ces fonctions sont traitées également de manière différente. A titre d'exemple les modules de puissance sont utilisés dans une application du type chaîne de traction.

Aussi un but de l'invention est-il un dispositif à éléments semi-conducteurs de puissance permettant de minimiser le nombre de radiateurs nécessaire au refroidissement des composants assurant la fonction complète des différents convertisseurs.

En d'autres termes, la présente invention vise plus particulièrement une installation dont l'architecture permet de minimiser le système de refroidissement des semi-conducteurs.

Ce type d'installation a pour avantage l'optimisation du volume du fait que les composants électroniques de puissance sont implantés sur un même axe.

En installant les composants de façon adaptée à leur niveau de perte, mais ceci sur un seul axe, le nombre de refroidisseurs dans les fonctions onduleur et hacheur auxiliaire ont diminuer par rapport à la fonction pont mixte à commutation forcée.

L'implantation mono axe a pour avantage de standardiser toute la mécanique nécessaire à l'ensemble des différents modules. Une telle implantation a également pour avantage d'utiliser le même câblage pour les trois fonctions onduleur, hacheur auxiliaire et pont mixte à commutation forcée.

Conformément à l'invention, le dispositif à éléments semi-conducteurs de puissance se caractérise en ce qu'il comprend en combinaison :
- une pile comportant, de façon alternée, au moins un élément semi-conducteur de puissance et au moins un radiateur assurant le rôle de dissipateur thermique et de liaison électrique,
- au moins un système de serrage des éléments semi-conducteurs de puissance,
- au moins un système de serrage des composants assurant la protection des éléments semi-conducteurs de puissance,
- au moins une cale en matériaux composite permettant d'isoler l'ensemble des éléments semi-conducteurs par rapport à l'ossature des différents modules,
- au moins un pavé conducteur en aluminium remplaçant les radiateurs n'étant pas rendus nécessaires grâce au choix du mode d'implantation dans les fonctions onduleur et hacheur auxiliaire.

Le dispositif à éléments semi-conducteurs de puissance de l'invention satisfait également à l'une au moins des caractéristiques suivantes:
- l'ensemble du dispositif est disposé selon un axe unique,
- l'ensemble du dispositif est maintenue dans une ossature comportant:
   ˙ une plaque support servant de base à la fois aux éléments semi-conducteurs de puissance et également aux semi-conducteurs de protection,
   ˙ une plaque de positionnement du système de serrage,
   ˙ deux colonnes associées à la plaque support et à la plaque de positionnement constituant l'ossature exerçant grâce au système de serrage, l'effort nécessaire au bon fonctionnement des semi-conducteurs de puissance,
- les éléments semi-conducteurs de protection sont maintenus au moyen d'une plaque de positionnement du second système de serrage de manière à contribuer à la transmission de l'effort, deux vis tirants et la plaque support.
- les éléments semi-conducteurs de puissance sont soit des diodes, soit des thyristor à extinction commandée par la gâchette (GTO), soit des diodes de protection.

D'autres buts, caractéristiques et avantages de l'invention apparaîtront à la lecture de la description du mode de réalisation préféré du dispositif à éléments semi-conducteurs de puissance, description faite en liaison avec les dessins dans lesquels:
- la figure 1 représente un dispositif à éléments semi-conducteurs de puissance du type onduleur conforme à l'invention,
- la figure 2 représente un dispositif à éléments semi-conducteurs de puissance du type pont mixte à commutation forcée conforme à l'invention,
- la figure 3 représente un dispositif à éléments semi-conducteurs de puissance du type hacheur auxiliaire conforme à l'invention.

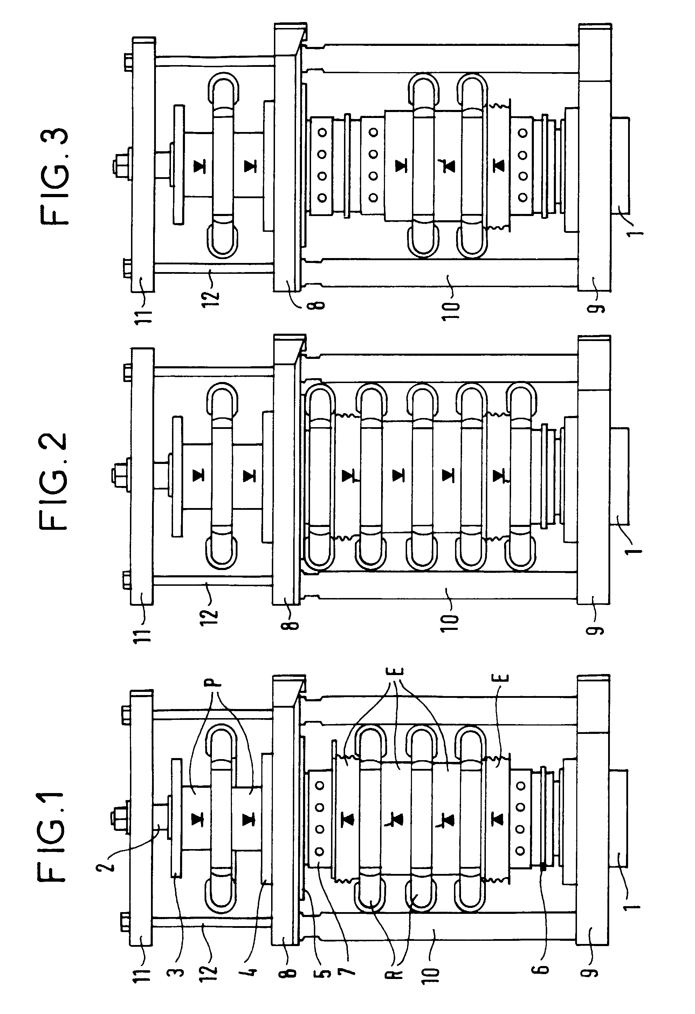

Les figures 1 à 3 représentent un dispositif à éléments semi-conducteurs de puissance conforme à l'invention, respectivement du type onduleur, pont mixte à commutation forcée et hacheur auxiliaire.

Le dispositif à éléments semi-conducteurs de puissance comprend en combinaison:
- une pile comportant, de façon alternée, au moins un élément semi-conducteur E de puissance et au moins un radiateur R assurant le rôle de dissipateur thermique et de liaison électrique,
- au moins un premier système de serrage 1 des éléments semi-conducteurs de puissance,
- au moins un second système de serrage 2 des composants assurant la protection des éléments semi-conducteurs de puissance,
- au moins une cale 3, 4, 5, 6 en matériaux composite permettant d'isoler l'ensemble des éléments semi-conducteurs par rapport à l'ossature des différents modules,
- au moins un pavé conducteur 7 en aluminium remplaçant les radiateurs R n'étant pas rendus nécessaires grâce au choix du mode d'implantation dans les fonctions onduleur et hacheur auxiliaire.

L'ensemble du dispositif est disposé selon un axe unique.

Conformément à un mode de réalisation préféré, l'ensemble du dispositif est maintenue dans une ossature comportant:
- une plaque support 8 servant de base à la fois aux éléments semi-conducteurs de puissance et également aux éléments semi-conducteurs de protection,
- une plaque de positionnement 9 du premier système de serrage 1,
- deux colonnes 10 associées à la plaque support 8 et à la plaque de positionnement 9 constituant l'ossature exerçant grâce au premier système de serrage 1, l'effort nécessaire au bon fonctionnement des éléments semi- conducteurs de puissance.

Les éléments semi-conducteurs de protection P sont maintenus au moyen d'une plaque de positionnement 11 du second système de serrage 2 de manière à contribuer à la transmission de l'effort, deux vis tirants 12 et la plaque support 8.

Les éléments semi-conducteurs de puissance E sont soit des diodes, soit des thyristor à extinction commandée par la gâchette, soit des diodes de protection.

Les cales 3, 4, 5, 6 sont de préférence en matériaux composite.

Les pavés conducteurs 7 sont de préférence en aluminium.

Les différentes pièces décrites ci-dessus sont toutes identiques pour les trois fonctions, seul la combinaison de l'implantation de certaines pièces permet d'obtenir des modules différents tout en minimisant le nombre de radiateur.

Il résulte de ce qui précède que le dispositif à éléments semi-conducteurs de puissance comprend sur un seul axe et en combinaison :
- des éléments semi-conducteurs de puissance principaux et de protection,
- des radiateurs tous identiques assurant le rôle de dissipateur thermique et
- des cales isolantes ou conductrices.

La position des éléments semi-conducteurs de puissance est fonction de leur perte liée au type de convertisseur.

L'ossature mécanique et le câblage est absolument identique pour les trois fonctions onduleur, hacheur auxiliaire et pont mixte à commutation forcée.

## Revendications

1. Dispositif à éléments semi-conducteurs de puissance caractérisé en ce qu'il comprend en combinaison:
- une pile comportant, de façon alternée, au moins un élément semi-conducteur E de puissance et au moins un radiateur R assurant le rôle de dissipateur thermique et de liaison électrique,
- au moins un premier système de serrage (1) des éléments semi-conducteurs de puissance,
- au moins un second système de serrage (2) des composants assurant la protection des éléments semi-conducteurs de puissance,
- au moins une cale (3, 4, 5, 6) permettant d'isoler l'ensemble des éléments semi-conducteurs par rapport à l'ossature des différents modules,
- au moins un pavé conducteur (7) remplaçant les radiateurs R n'étant pas rendus nécessaires grâce au choix du mode d'implantation dans les fonctions onduleur et hacheur auxiliaire.

2. Dispositif selon la revendication 1, dans lequel l'ensemble du dispositif est disposé selon un axe unique.

3. Dispositif selon l'une quelconque des revendications 1 ou 2, dans lequel l'ensemble du dispositif est maintenue dans une ossature comportant:
˙ une plaque support (8) servant de base à la fois aux éléments semi-conducteurs de puissance et également aux éléments semi-conducteurs de protection,
˙ une plaque de positionnement (9) du premier système de serrage (1),
˙ deux colonnes (10) associées à la plaque support (8) et à la plaque de positionnement (9) constituant l'ossature exerçant grâce au premier système de serrage (1), l'effort nécessaire au bon fonctionnement des éléments semi-conducteurs de puissance.

4. Dispositif selon l'une quelconque des revendications 1 à 3, dans lequel les éléments semi-conducteurs de protection P sont maintenus au moyen d'une plaque de positionnement (11) du second système de serrage (2) de manière à contribuer à la transmission de l'effort, deux vis tirants (12) et la plaque support (8).

5. Dispositif selon l'une quelconque des revendications 1 à 4, dans lequel les éléments semi-conducteurs de puissance E sont soit des diodes, soit des thyristor à extinction commandée par la gâchette, soit des diodes de protection.

6. Dispositif selon l'une quelconque des revendications 1 à 5, dans lequel les cales (3, 4, 5, 6) sont en matériaux composite.

7. Dispositif selon l'une quelconque des revendications 1 à 6, dans lequel les pavés conducteurs (7) sont en aluminium.
